(19) Europäisches Patentamt / European Patent Office / Office européen des brevets

(11) **EP 2 688 111 A2**

(12) **EUROPEAN PATENT APPLICATION**
published in accordance with Art. 153(4) EPC

(43) Date of publication:
**22.01.2014 Bulletin 2014/04**

(21) Application number: **12757078.6**

(22) Date of filing: **16.03.2012**

(51) Int Cl.:
**H01L 31/042** (2006.01)          **C08J 5/18** (2006.01)
**C08L 27/12** (2006.01)

(86) International application number:
**PCT/KR2012/001901**

(87) International publication number:
**WO 2012/125000 (20.09.2012 Gazette 2012/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.03.2011   KR 20110023839
13.03.2012   KR 20120025681**

(71) Applicant: **LG Chem, Ltd.
Seoul 150-721 (KR)**

(72) Inventors:
• **KWON, Yoon Kyung
Daejeon 305-728 (KR)**
• **KIM, Hyun Cheol
Daejeon 305-707 (KR)**

(74) Representative: **Goddar, Heinz J.
Boehmert & Boehmert
Pettenkoferstrasse 20-22
80336 München (DE)**

(54) **ENVIRONMENTALLY FRIENDLY BACKSHEET FOR SOLAR CELL AND METHOD FOR MANUFACTURING SAME**

(57)    An environmentally friendly backsheet for a solar cell, a method of manufacturing the same, and a photoelectric cell module are provided. The backsheet for a solar cell is manufactured by preparing an aqueous dispersion composition by dispersing a fluorine-based polymer in water, applying the aqueous dispersion composition to a substrate, and melting the aqueous dispersion composition. Therefore, compared to the conventional art using an organic solvent, an increase in production cost may be prevented, and the backsheet is environmentally friendly since an organic solvent having high toxicity is not used. In addition, the backsheet has better physical properties such as adhesive strength and color change stability under the extreme conditions (high temperature and humidity), compared to a backsheet for a solar cell commercially available in the current market.

FIG.1

EP 2 688 111 A2

**Description**

CROSS-REFERENCE TO RELATED APPLICATION

This application claims priority to and the benefit of Korean Patent Applications Nos. 2011-0023839, filed March 17, 2011 and 2012-0025681, filed March 13, 2012, the disclosures of which are incorporated herein by reference in its entirety.

BACKGROUND

**1. Technical Field**

The present invention relates to an environmentally friendly backsheet for a solar cell, a solar cell having the same, and a method of manufacturing a backsheet for a solar cell.

**2. Related Art**

Nowadays, there is increasing attention to new regenerative energy and clean energy due to the Earth's environmental problems and the depletion of fossil fuels, and particularly, solar energy is attracting attention as a representative pollution-free energy source which can solve the problems of environmental pollution and the depletion of fossil fuels.
A solar cell to which the principle of solar light power generation is applied is a device converting solar light into electrical energy. The solar cell is manufactured in a type of unit through several packaging processes in order to protect the cell because the cell is exposed to an external environment for a long time to easily absorb solar light. Here, such a unit is called a solar cell module.
Generally, the solar cell module uses a backsheet having excellent weather resistance and durability to protect a solar cell even when the solar cell is exposed to an external environment for a long time. Such a backsheet generally includes a fluorine-based resin layer with durability and weather resistance, which is stacked at one side of a substrate.
However, since the conventional weather-resistant resin layer for a backsheet has poor adhesive strength to a polyethylene terephthalate (PET) film typically used as a substrate of, a fluorine-based polymer film may be obtained using an extrusion or casting process and then laminated on the substrate using a urethane-based adhesive. In this case, however, expensive film manufacturing equipment may be required, the use of an adhesive may be needed, and an additional adhesive coating process and a lamination process may be further performed. In addition, a film having a larger thickness than that required for easy film handling in a film manufacturing process should be used, use of various additives and fillers is limited, and a high processing temperature is required.
On the other hand, when a fluorine-based polymer film is manufactured by preparing a resin suspension or solution, coating the suspension or solution on a substrate and then drying the suspension or solution, it is also undesirable in terms of costs of raw materials and effects to the environment since the process uses an organic solvent, such as dimethylformamide (DMF), dimethylacetylamide (DMAC) or N-methyl pyrrolidone (NMP), which has a high boiling point.
Accordingly, there is an ongoing demand for an environmentally friendly backsheet of a solar cell which has excellent durability and weather resistance and reducing the production costs of the same.

SUMMARY

The present invention is directed to providing an economical, environmentally friendly backsheet for a solar cell which has excellent physical properties.
The present invention is also directed to providing a method of manufacturing a backsheet for a solar cell.
The present invention is also directed to providing a solar cell including a backsheet for a solar cell.

BRIEF DESCRIPTION OF THE DRAWINGS

The above and other objects, features and advantages of the present invention will become more apparent to those of ordinary skill in the art by describing in detail the exemplary embodiments thereof with reference to the attached drawings, in which:

FIG. 1 is a cross-sectional view of a backsheet for a solar cell according to an exemplary embodiment of the present invention;
FIG. 2 shows a process of manufacturing a backsheet for a solar cell according to an exemplary embodiment of the present invention;

FIG. 3 is a photograph of a surface of a resin layer in a backsheet for a solar cell in Example 1 after an aqueous dispersion is applied;

FIG. 4 is a photograph of a surface of a resin layer in a backsheet for a solar cell in Example 1 after an aqueous dispersion has melted;

FIG. 5 is a photograph of a surface of a resin layer in a backsheet for a solar cell in Example 2 after an aqueous dispersion is applied;

FIG. 6 is a photograph of a surface of a resin layer in a backsheet for a solar cell in Example 2 after an aqueous dispersion has melted; and

FIG. 7 is a photograph of a surface of a resin layer in a backsheet for a solar cell in Comparative Example 1 after an aqueous dispersion has melted.

DETAILED DESCRIPTION OF EXEMPLARY EMBODIMENTS

One aspect of the present invention provides a backsheet for a solar cell, which includes: a substrate and a resin layer having a fluorine-based polymer formed on at least one surface of the substrate. Particularly, unlike the conventional art using an organic solvent, the resin layer of the present invention is a coating layer formed with a dispersion composition including water and a fluorine-based polymer, and the present invention is environmentally friendly and ensures excellent physical properties.

A backsheet for a solar cell according to the exemplary embodiments of the present invention satisfies the following Equation 1:

$$[\text{Equation 1}]$$

$$\triangle YI = YI_b - YI_a < 3$$

$\triangle YI$ is a value obtained by subtracting a YI value ($YI_a$) obtained after the backsheet is left for 0 hours at 121°C and a relative humidity of 100% under 2 atm from a YI value ($YI_b$) obtained after the backsheet is left under high temperature and humidity. The YI value is a yellowness index obtained after reflectivity at 400 to 800 nm is measured. Here, $YI_b$ is a value obtained after the backsheet is left under conditions for a pressure cooker test (PCT) [121°C, relative humidity 100%] for 75 hours, or at 85°C and relative humidity of 85% for 3000 hours.

Another aspect of the present invention provides a method of manufacturing a backsheet for a solar cell, which includes: applying a dispersion composition including a fluorine-based polymer and water to at least one surface of a substrate; and forming a resin layer by melting the applied dispersion composition.

Still another aspect of the present invention provides a solar cell having a backsheet for a solar cell.

Hereinafter, exemplary embodiments of the present invention will be described in detail. Detailed descriptions on related functions or configurations known will be omitted. The following embodiments are described in order to enable those of ordinary skill in the art to embody and practice the present invention. To help understand the present invention, parts unrelated to the description are omitted, and to clearly express various layers and regions, thicknesses are enlarged. The scope of the present invention is not limited by thicknesses, sizes and ratios shown in the drawings.

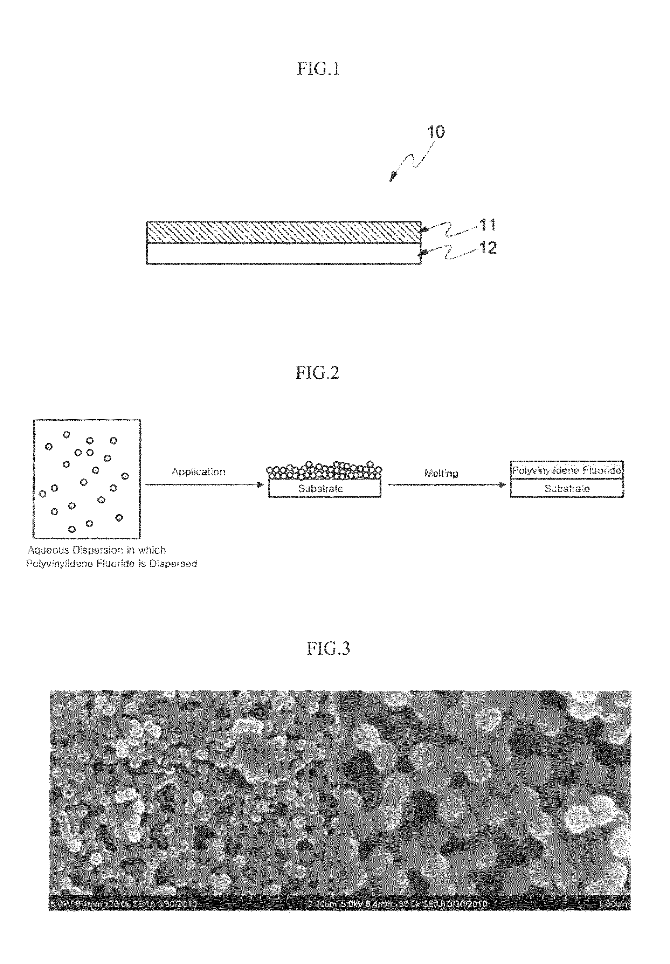

FIG. 1 is a cross-sectional view of a backsheet for a solar cell according to an exemplary embodiment of the present invention. Referring to FIG. 1, a backsheet 10 for a solar cell according to an exemplary embodiment of the present invention includes a substrate 12 and a resin layer 11, including a fluorine-based polymer formed on at least one surface of the substrate 12.

A specific kind of the substrate 12 included in the backsheet 10 for a solar cell according to the present invention is not particularly limited. Various materials known in the art may be used to form the substrate 12, and may be suitably selected according to required function and use.

In one embodiment of the present invention, any kind of a metal film or polymer film may be used as the substrate. Here, the metal film may be composed of a conventional metal component, for example, aluminum or iron, depending on its use. Examples of the polymer film may include, but are not limited to, an acryl film, a polyolefin film, a polyamide film, a polyimide film, a polyurethane film or a polyester film. The polyester film may be, but is not limited to, a single or stacked sheet or a coextruded product of a polyethylene terephthalate (PET) film, a polyethylene naphthalate (PEN) film or a polybutylene terephthalate (PBT) film.

In addition, the polyester film may have an excellent hydrolysis resistance property. The polyester film having an excellent hydrolysis resistance property may have a low content of oligomer generated in the condensation polymerization. Moreover, by applying additional thermal treatment to improve the hydrolysis resistance to the polyester film, the water content in polyester and the percentage of contraction may be reduced, and thus the hydrolysis resistance property may be further improved. Also, a commercially available product having an excellent hydrolysis resistance property may be used as the film.

The thickness of the substrate is not specifically limited, but may be in a range of approximately 50 to 500 $\mu$m, or approximately 100 to 300 $\mu$m. When the thickness of the substrate is adjusted within the above range, a multilayer film may maintain excellent electric conductivity, moisture barrier property, mechanical property and easy handling. Meanwhile, in the present invention, the thickness of the substrate is not limited to the above-mentioned range, but may be suitably adjusted as needed.

According to the exemplary embodiments of the present invention, the substrate may be subjected to high frequency spark discharging such as corona or plasma treatment, thermal treatment, flame treatment, treatment with a coupling agent, primer treatment or chemical activation using gas-phase Lewis acid (eg. BF$_3$), sulfuric acid or high temperature sodium hydroxide in order to further improve adhesive strength with respect to the resin layer containing a fluorine-based polymer.

In addition, an inorganic oxide may be deposited on one or both surfaces of the substrate to further improve a moisture barrier property. The kind of inorganic oxide is not particularly limited, but any having a moisture barrier property may be employed without limitation. In the present invention, for example, as an inorganic oxide, a silicon oxide or aluminum oxide may be used, but the present invention is not limited thereto. In the present invention, a method of forming an inorganic oxide deposited layer on one or both surfaces of the substrate is not specifically limited, and thus may be a deposition method generally known in the art. Here, surface treatment such as spark discharging using corona or plasma, flame treatment, treatment with an anchoring agent or coupling agent, primer treatment or chemical activation may also be subjected to a deposition-treated layer.

The backsheet 10 for a solar cell according to the present invention includes a resin layer 11 having a fluorine-based polymer formed on the substrate 12. The resin layer 11 is a coating layer formed with a dispersion composition including a fluorine-based polymer, particularly an aqueous dispersion composition in which a fluorine-based polymer is dispersed in water. The present invention is to gain an environmentally friendly approach by using water instead of an organic solvent conventionally used, confirming a backsheet of excellent quality.

The kind of fluorine-based polymer composing the resin layer 11 according to the present invention may be a homopolymer or copolymer including at least one monomer selected from the group consisting of vinylidene fluoride (VDF), vinyl fluoride (VF), tetrafluoroethylene (TFE), hexafluoropropylene (HFP), chlorotrifluoroethylene (CTFE), trifluoroethylene, hexafluoroisobutylene, perfluoro butylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD) and perfluoro-2-methylene-4-methyl-1,3-dioxolane (PMD) in a polymerized form, or a mixture thereof.

In one embodiment of the present invention, a fluorine-based polymer may be a homopolymer or copolymer including polymerized vinylidene fluoride (VDF), a homopolymer or copolymer including polymerized vinyl fluoride (VF), or a mixture including at least two thereof, and for example, a copolymer including polymerized vinylidene fluoride (VDF).

In addition, the fluorine-based polymer may be a copolymer including vinylidene fluoride (VDF) and a comonomer, or a copolymer including vinyl fluoride (VF) and a comonomer. A comonomer which may be included in the copolymer in a polymerized form may be a fluorine-based monomer, which is at least one or two of tetrafluoroethyelne (TFE), hexafluoropropylene (HFP), chlorofluoroethylene (CTFE), trifloroethylene, hexafluoroisobutylene, perfluoro (butylethylene), perfluoro(methylvinylether (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD) and perfluoro-2-methylene-4-methyl-1,3-dioxolane (PMD), but is not limited to, for example, at least one or two of hexafluoropropylene and chlorotrifluoroethylene.

In addition, the comonomer in the fluorine-based copolymer may have a content of 50 wt% or less, 40 wt% or less, 1 to 40 wt%, 10 to 30 wt%, or 10 to 20 wt% based on a total weight of the fluorine-based copolymer. Within the above-mentioned range of the comonomer, the backsheet for a solar cell may ensure durability and weather resistance, and induce effective inter-diffusion and low drying temperature (drying when melting).

The fluorine-based polymer composing the resin layer according to the present invention may be a non-functionalized fluoropolymer. That is, the non-functionalized fluoropolymer is consisted of at least one fluorine-based polymer and not modified with acrylates or etc. The non-functionalized pure fluorine-based polymer provides excellent weather resistance, compared to a fluorine-based polymer functionalized with an acryl modified fluorine-based polymer, a crosslinkable functional group, a carboxyl group, an epoxy group, a hydroxyl group, an acid anhydride group, an isocyanate group or etc. Since the functionalized fluorine-based polymer is formed by adding a polymerizable monomer having a functional group to a fluorine-based polymer, the ratio of fluorine decreases, and thus weather resistance decreases. In addition, the remaining unreacted functional group may be destroyed or hydrolyzed by heat, moisture or UV ray due to decreased stability. Therefore, it will bring yellowing or a decrease in adhesive strength to the film later.

A fluorine-based polymer which can be used in the exemplary embodiments of the present invention may be manufactured by emulsion polymerization, and it has a particle size of 10 $\mu$m or less, or 0.1 to 2 $\mu$m. In one example, since vinylidene fluoride polymer manufactured by emulsion polymerization has a small and uniform particle size, the polymer can easily be applied uniformly to a substrate and obtain a uniformly coated appearance through a melting process.

In the exemplary embodiments of the present invention, the fluorine-based polymer may have a weight average molecular weight of 50,000 to 1,000,000. In the other exemplary embodiments, the fluorine-based polymer may have a weight average molecular weight of 100,000 to 700,000, or 300,000 to 500,000. The present invention may ensure excellent dispersibility and other physical properties. In the present invention, a weight average molecular weight is a conversion value of the standard polystyrene measured by gel permeation chromatography (GPC).

In the exemplary embodiments of the present invention, the fluorine-based polymer may have a melting point of 80 to 175°C, or 120 to 165°C. In the present invention, when the melting point of the resin is adjusted to 80°C or more, deformation of the backsheet for a solar cell in use may be prevented, and when the melting point of the resin is adjusted to 175°C or less, the uniformly coated appearance may be obtained by melting a fluorine-based polymer particle at a low processing temperature.

In the exemplary embodiments of the present invention, a dispersion composition forming a resin layer may include water at a content of 100 to 2000 parts by weight based on 100 parts by weight of a fluorine-based polymer. Here, when the content of water is less than 100 parts by weight, dispersion stability may decrease, and when the content of water is more than 2000 parts by weight, the coating thickness may be difficult to adjust.

In the exemplary embodiments of the present invention, the content of the fluorine-based polymer included in the dispersion composition used to form the resin layer may be 70 wt% or more based on the total solid content (excluding a pigment), and in the other exemplary embodiments, the content of the fluorine-based polymer may be 80 wt% or more, or 90 wt% or more. When the content of the fluorine-based polymer is less than 70 wt%, mechanical property and weather resistance of the resin layer may decrease.

The backsheet for a solar cell according to exemplary embodiments of the present invention also satisfies the following Equation 1:

$$[\text{Equation 1}]$$

$$\triangle\text{YI} = \text{YI}_b - \text{YI}_a < 3$$

$\triangle$YI is a value obtained by subtracting YI value ($\text{YI}_a$) obtained after the backsheet is left for 0 hours at 121°C and a relative humidity of 100% under 2 atm from YI value ($\text{YI}_b$) obtained after the backsheet is left under high temperature and humidity. The YI value is a yellowness index obtained after reflectivity at 400 to 800 nm is measured. Here, $\text{YI}_b$ is a value obtained after the backsheet is left under PCT conditions [121°C, relative humidity: 100%] for 75 hours, or at 85°C and a relative humidity of 85% for 3000 hours.

The backsheet for a solar cell according to the exemplary embodiments of the present invention may further include a surfactant so that the resin layer can have good dispersibility and wettability with respect to the substrate. The surfactant may be used at a content of 0.01 to 10 parts by weight, 0.1 to 5 parts by weight, or 0.5 to 1 parts by weight based on 100 parts by weight of the fluorine-based polymer. When the surfactant is used at a content of less than 0.01 parts by weight based on 100 parts by weight of the fluorine-based polymer, there are problems with the dispersibility and wettability, and thus it is difficult to uniformly apply the fluorine-based polymer particles to the substrate. When the surfactant is used at a content of more than 10 parts by weight, weather resistance may decrease due to an excessive amount of the surfactant used.

The surfactant which can be used in the exemplary embodiments of the present invention may be non-ionic, cationic or anionic. To have improved miscibility with a fluorine-based polymer, poly(vinylidene fluoride) (PVDF), a fluorine-based surfactant, for example, an anionic fluorine-based surfactant produced by Dupont such as Zonyl FS-62, FSA, FSE, FSJ, FSP, TBS or UR; a non-ionic fluorine-based surfactant such as Zonyl FSO, FSO-100, FSN or FS-300; a cationic fluorine-based surfactant such as Zonyl FSD; or a fluorine-based surfactant simultaneously having an anion and a cation such as Zonyl FSK or BYK340 may be used. Other than the fluorine-based surfactant, a water-soluble polymer such as polyvinylalcohol, polyvinylpyrrolidone, methyl cellulose, ethyl cellulose or a styrene-maleic anhydride copolymer; a surfactant such as an anionic surfactant such as sodium oleate or sodium lauryl sulfate, a non-ionic surfactant such as polyoxyethylene alkyl ether, polyoxyethylene alkylphenyl ether, polyoxyethylene fatty acid ester, sorbitan fatty acid ester, polyoxy sorbitan fatty acid ester, polyoxyethylene alkyl amine or glycerin fatty acid ester or a cationic surfactant including a quaternary ammonium such as lauryl amine acetate, alkyl amine salt or lauryltrimethyl ammonium chloride; a phosphate such as calcium phosphate, magnesium phosphate, aluminum phosphate or zinc phosphate; a pyrophosphate such as calcium pyrophosphate, magnesium pyrophosphate, aluminum pyrophosphate, zinc pyrophosphate; or an inorganic dispersing agent such as calcium carbonate, magnesium carbonate, calcium hydroxide, magnesium hydroxide, aluminum hydroxide, calcium meta silicate, calcium lactate, barium sulfate, colloidal silica or fumed silica may be used.

In the exemplary embodiments of the present invention, as a dispersion composition forming the resin layer, a fluorine-based polymer dispersion polymerized in emulsion polymerization of the fluorine-based polymer may be used without an additional surfactant. That is, the fluorine-based polymer dispersion may be a PVDF emulsion dispersion. In addition, after the fluorine-based polymer is formed by emulsion polymerization and dried, the above-mentioned surfactant may be added to water, and the prepared fluorine-based polymer particles may be dispersed.

The resin layer of the present invention may further include a pigment or filler for improved efficiency of power generation of a solar cell, improved physical properties of the backsheet of a solar cell, adjustment of color or opacity of the resin layer or for other purposes, in addition to the above-mentioned components. Here, examples of the pigments or fillers to be used include a carbon black, a metal oxide such as chromium oxide ($Cr_2O_3$), iron oxide ($Fe_2O_3$ or $Fe_3O_4$), complex metal oxide, metal salt, or other organic pigments. In addition, a white pigment such as titanium dioxide ($TiO_2$), barium sulfate ($BaSO_4$), barium titanate ($BaTiO_3$), strontium titanate ($SrTiO_3$), calcium titanate ($CaTiO_3$), calcium carbonate, lead titanate ($PbTiO_3$), zinc oxide, zinc sulfide, magnesium oxide ($MgO$), aluminum oxide ($Al_2O_3$), silica ($SiO_2$) or zirconia ($ZrO_2$) may be used, but the present invention is not limited thereto.

The kind of the pigment which can be used in the backsheet for a solar cell is not specifically limited, but one having good weather resistance can be selected because the backsheet is exposed to an external environment for a long time. For example, a pigment inducing color change by breaking a double bond in the pigment such as a dye, or a pigment inducing yellowing by breaking a polymer chain around the pigment such as titanium dioxide having a photocatalytic function should be avoided.

As the particle size of the titanium dioxide gets smaller, the photocatalytic function becomes active. Therefore, titanium dioxide having a size of approximately 0.2 $\mu$m or more may exhibit better dispersibility and reflectivity. Particularly, when titanium dioxide has a size of less than 0.2 $\mu$m, reflectivity decreases in a long wavelength range (around 800 nm), which is not effective in the aspect of an external quantum efficiency of a crystallized silicon solar cell.

As the dispersibility of the pigment is improved, white reflectivity may further increase, or black transmittance may further decrease. Therefore, it is better to increase dispersibility as much as possible. To improve the dispersibility of the pigment, it is preferable that a pigment subjected to surface treatment to have better dispersibility is selectively used, or a suitable wet dispersing agent-type pigment dispersing agent is used. A method of dispersing a pigment may be a method using a high speed mixer or a ball mill or micro mill.

The content of the pigment or filler may be 1 to 200 parts by weight based on 100 parts by weight of the fluorine-based polymer. When the content of the pigment or filler is less than 1 part by weight based on 100 parts by weight of the fluorine-based polymer, there are problems in reflectivity and UV blocking property. When the content of the pigment or filler is more than 200 parts by weight, the resin layer is easily destroyed, and scratch resistance decreases.

In addition, the resin layer of the present invention may further include conventional components such as a UV stabilizer, a thermal stabilizer or a barrier particle.

The resin layer including the above-mentioned components in the present invention, that is, a resin layer which is a product formed by melting a composition formed in an aqueous dispersion in which the components are dispersed, may have a thickness of approximately 1 to 50 $\mu$m, or 3 to 30 $\mu$m. When the thickness of the resin layer including the fluorine-based polymer is less than 1 $\mu$m, , the resin layer is too thin due to a very small thickness, and thus insufficiently filled with a filler and furthermore the light blocking property may be decreased. When the thickness of the resin layer is more than 50 $\mu$m, the production cost may increase.

The resin layer including the fluorine-based polymer in the present invention may be a coating layer. The term "coating layer" used herein is a resin layer formed by a coating process. More specifically, the "coating layer" refers to a resin layer including the above-described fluorine-based polymer formed by coating a coating solution prepared by dispersing components comprising the resin layer in water such as distilled water on a substrate, not by laminating a sheet formed by casting or extrusion to a substrate using an adhesive.

FIG. 1 shows a backsheet 10 for a solar cell according to the exemplary embodiments of the present invention, in which a resin layer 11 is formed only on one surface of a substrate 12. In the other exemplary embodiments of the present invention, a backsheet for a solar cell (not shown) may include resin layers formed on both surfaces of a substrate.

In addition, a primer layer giving adhesive strength may be further included between the substrate and the resin layer. Here, the primer layer may be formed on one or both surfaces of the substrate.

The primer layer may be formed on the surface of a substrate before the resin layer is formed. The primer layer may be formed using compounds having a functional group improving adhesive strength to the resin layer. Specifically, the primer layer may be formed using at least one selected from the group consisting of polyamine, polyamide, amorphous acrylamide, polyethyleneimine, ethylene copolymer or terpolymer, maleated polyolefin, acrylate or methacrylate polymer, polyester, polyurethane epoxy polymer and epoxyacryl-based oligomer.

The backsheet for a solar cell according to the exemplary embodiments of the present invention may further include various functionalized layers known in the art when necessary. The functionalized layer may be an adhesive layer or an insulating layer. For example, in the backsheet for a solar cell of the present invention, the above-described resin layer is formed on one surface of the substrate, and an adhesive layer and an insulating layer may be sequentially formed on the other surface of the substrate. The adhesive layer or insulating layer may be formed by various methods known in the art. For example, the insulating layer may be an ethylenevinylacetate (EVA) or low-density linear polyethylene (LDPE) layer. The ethylenevinylacetate (EVA) or low-density linear polyethylene (LDPE) layer may serve as an insulating layer, and also serve to increase adhesive strength to an encapsulant of a solar cell module, save on production cost, and maintain excellent re-workability.

The backsheet for a solar cell has excellent insulability with a solar cell, durability and weather resistance against an external environment, processability, productivity and reduction in production cost.

Still another aspect of the present invention provides a method of manufacturing a backsheet for a solar cell, the method including forming a resin layer having a fluorine-based polymer on a substrate. The method includes applying a dispersion composition on at least one surface of the substrate; and forming a resin layer by melting the applied dispersion composition.

FIG. 2 is a schematic diagram showing a method of manufacturing a backsheet for a solar cell according to an exemplary embodiment of the present invention. First, in the present invention, to manufacture the backsheet for a solar cell, a dispersion composition including a fluorine-based polymer and water is used.

For this purpose, additives such as a surfactant and a pigment may be further included in the dispersion composition during preparation of the dispersion composition by dispersing the fluorine-based polymer in water. A chemical interaction such as a van der Waals bond, a hydrogen bond, an ionic bond or a covalent bond may be generated by a functional group included in an additive such as a filler or a pigment dispersing agent which may be included in the resin layer, and thus adhesive strength between the resin layer and the substrate may also be improved.

Afterwards, the method of the present invention includes applying the dispersion composition to the substrate and forming a resin layer by melting the dispersion composition.

As shown in FIG. 2, when the dispersion composition is applied to the substrate, fluorine-based polymer particles are arranged above the substrate, and the particles are changed into a film phase by being melted by heat. Accordingly, to obtain a uniform film phase in the above-mentioned step, the fluorine-based polymer may have a particle size of 10 $\mu$m or less. Generally, the fluorine-based polymer is formed by an emulsion method (emulsion polymerization). A method of forming the fluorine-based polymer in the above-mentioned size is not specifically limited, but emulsion polymerization is preferable to form the fluorine-based polymer in a small and uniform size of 10 $\mu$m or less.

The melting is performed at a temperature higher than the melting point, for example, 150 to 250°C. Here, when the melting temperature is less than 150°C, the dispersed fluorine-based polymer does not melted, and when the melting temperature is more than 250°C, the substrate is thermally damaged and thus easily destroyed.

In the exemplary embodiments of the present invention, a method of applying the resin layer to the substrate is not specifically limited. For example, the application may be performed by any of the methods that may form a uniform coating layer, including known printing methods such as offset printing and gravure printing, and known application methods such as roll coating, knife edge coating and gravure coating. In the present invention, various methods known in the art, other than the above-mentioned methods, may be applied, and the coating solution may further include various additives when necessary.

A specific kind of substrate that may be used in the method of the present invention is described above, and the substrate may be in advance subjected to suitable deposition treatment, thermal treatment, plasma treatment or corona treatment. A substrate previously treated with the above treatment method may be used.

A backsheet for a solar cell manufactured by the method of manufacturing a backsheet for a solar cell according to the present invention satisfies Equation 1.

[Equation 1]

$$\triangle YI = YI_b - YI_a < 3$$

$\triangle$YI is a value obtained by subtracting YI value ($YI_a$) obtained after the backsheet is left for 0 hours at 121°C and a relative humidity of 100% under 2 atm from YI value ($YI_b$) obtained after the backsheet is left under high temperature and humidity. The YI value is a yellowness index obtained after reflectivity at 400 to 800 nm is measured. Here, $YI_b$ is a value obtained after the backsheet is left under PCT conditions [121°C, relative humidity: 100%] for 75 hours, or at 85°C and a relative humidity of 85% for 3000 hours.

In addition, the method according to the present invention may further include forming a primer layer on at least one surface of the substrate before the resin layer is formed.

In the present invention, a coating solution applied to form the resin layer may further include various additives such as a pigment, a filler, a UV stabilizer or a thermal stabilizer, in addition to the fluorine-based polymer. Each additive may be dispersed with the fluorine-based polymer, or mixed with a composition including the fluorine-based polymer after being separately prepared from the above-mentioned components in a mill base type. A chemical interaction such as a van der Waals bond, a hydrogen bond, an ionic bond or a covalent bond may be generated by a functional group included in an additive such as a filler or pigment dispersing agent which may be included in the resin layer, and thus adhesive strength between the resin layer and the substrate may also be improved.

In the present invention, a method of preparing a coating solution, or a ratio of each component included in the coating solution are not specifically limited, and various methods known in the art are suitably used.

In the method of manufacturing a backsheet for a solar cell of the present invention, the content and kind of the fluorine-based polymer, the kinds of the substrate and the resin layer, and descriptions about the additive and the primer layer which may further be included is the same as described above.

The backsheet for a solar cell according to the present invention may include a resin layer having a fluorine-base polymer as described above, and specifically, in the process of manufacturing the backsheet for a solar cell, the fluorine-based polymer included in the resin layer may be inter-diffused into the substrate or a surface-treated layer of the substrate at an interface between the resin layer and the substrate or a surface-treated layer of the substrate. Therefore, adhesive strength may be improved due to a chemical covalent bond formed between the substrate and the resin layer, and chain entanglement and a van der Waals force between molecular chains.

Yet another aspect of the present invention provides a solar cell having the backsheet for a solar cell.

The solar cell of the present invention is not specifically limited as long as it includes the backsheet for a solar cell, and may be formed in various structures known in the art.

Usually, a solar cell may include a transparent front substrate, a backsheet and a photovoltaic cell or photovoltaic cell array encapsulated by an encapsulant between the front substrate and the backsheet. That is, gaps around solar cells arranged in series or parallel are filled with an encapsulant composed of thermosetting plastic (ethylene-vinylacetate copolymer), the side of the solar cell where solar light reaches may be covered with a transparent front substrate, a glass, and the other side thereof may be protected by the backsheet for a solar cell according to the present invention.

An example of an active layer constituting the photovoltaic cell or photovoltaic cell array may be a crystalline or amorphous silicon wafer, or a compound semiconductor such as copper indium gallium selenide (CIGS) or cadmium tellurium sulfide (CTS).

The backsheet for a solar cell of the present invention may be applied to various solar cell modules known in the art including a solar cell module having the active layer described above without limitation. In this case, a method of composing the module or another kind of material is not specifically limited.

Hereinafter, exemplary embodiments of the present invention will be described in detail. However, the present invention is not limited to the embodiments disclosed below, but can be implemented in various forms. The following embodiments are described in order to enable those of ordinary skill in the art to embody and practice the present invention.

Physical properties of films manufactured in Examples and Comparative Examples were measured by the following manners:

1. Cross-hatch Adhesive Strength

A cross-cut test was performed according to standards ASTM D3002/D3359. Specifically, a specimen was cut 11 lines each in horizontal and vertical directions, thereby obtaining 100 square-shaped lattices having a size of 1 mm x 1 mm. Afterwards, when a CT-24 adhesive tape available from Nichiban was attached to the surface that was cut and then detached, the state of the surface detached along with the tape was observed and evaluated based on the following criteria:

<Criteria for Evaluating Cross-Hatch Adhesive Strength>

    5B: when no surface was detached
    4B: when the detached surface was 5% or less based on total area
    3B: when the detached surface was 5 to 15% or less based on total area
    2B:when the detached surface was 15 to 35% or less based on total area
    1B: when the detached surface was 35 to 65% or less based on total area
    0B: when almost all of the surface was detached

2. 180-degree Peel Strength

Peel strength was measured by cutting a specimen to have a width of 10 mm, and peeling the specimen at a speed of 4.2 mm/sec and at an angle of 180 degrees according to ASTM D1897.

<Criteria for Evaluating 180-degree Peel Strength>

Coat-T: when it was impossible to precisely measure peel strength because a resin layer was torn during peeling due to very excellent adhesive strength
PVF-T: when it was impossible to precisely measure peel strength because a PVF layer was torn during peeling due to excellent adhesive strength

3. Examination of Color Change

Reflectivity of backsheets for a solar cell manufactured in Examples and Comparative Examples were measured in the range of 400 to 800 nm using a Shimadzu UV Vis spectrometer (UV-3000), and then yellowness indexes (YI values) were obtained therefrom according to ASTM D1925 (refer to the following Equation 1).

[Equation 1]

$$YI = [100(1.28X_{CIE} - 1.06Z_{CIE})]Y_{CIE}$$

YI is a value calculated by an UV/VIS/NIR spectrometer using a color difference analysis program (ASTM D1925), and $X_{CIE}$, $Y_{CIE}$ and $Z_{CIE}$ are relative values represented by red, green and blue color coordinates, respectively.

4. Pressure Cooker Test (PCT)

Backsheets for a solar cell manufactured in Examples and Comparative Examples were left for 25, 50 and 75 hours in an oven maintaining conditions of 2 atm, 121°C and 100% R.H., and then changes in adhesive strength were observed. In the specification, the unit "R.H." refers to relative humidity.

5. Damp Heat Test

Backsheets for a solar cell manufactured in Examples and Comparative Examples were left in an oven maintaining conditions of 85 °C and 85% R.H. for 1,000, 2,000 and 3,000 hours, and then changes in adhesive strength were observed.

<Example 1>

**Preparation of Substrate**

Corona treatment was performed to a surface of a PET film (available from Kolon) having a thickness of 250 $\mu$m, which was previously treated with an acryl primer on one side.

**Formation of Resin Layer**

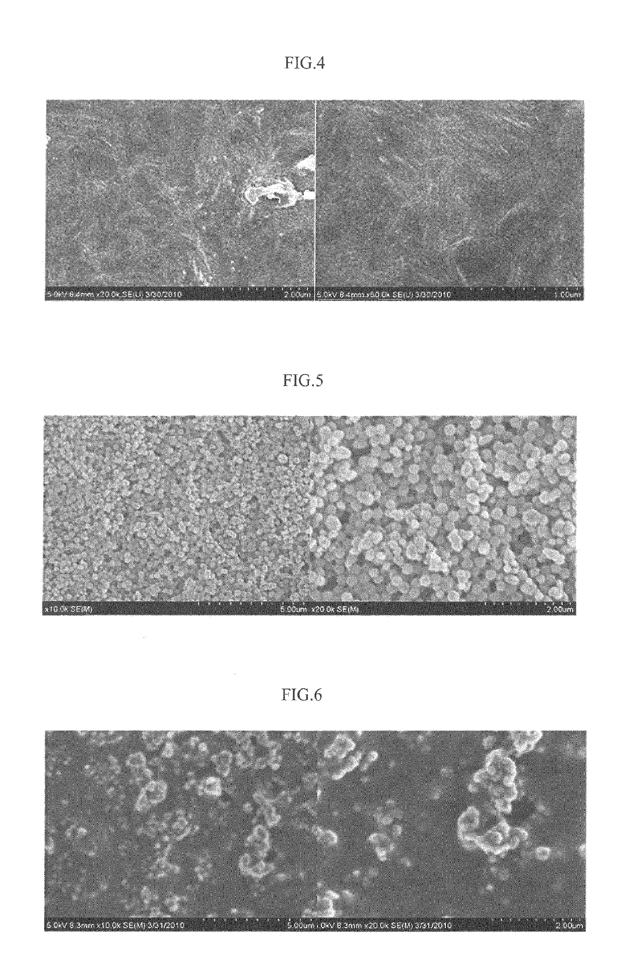

An aqueous dispersion was prepared by adding 20 g of 5% polyvinylalcohol (PVA, POLINOL P17 available from Oriental Chemical Industries) to 380 g of distilled water, and dispersing 100 g of emulsion-polymerized non-functionalized PVDF [Hylar561] which had a particle size of approximately 0.3 $\mu$m. The aqueous dispersion was applied to the previously prepared substrate and then melted at 200°C for 5 minutes to form a resin layer. Therefore, a backsheet for a solar cell was manufactured. Photographs of the surface of the resin layer after the aqueous dispersion was applied and melted were taken, shown in FIGS. 3 and 4, respectively.

<Example 2>

A backsheet for a solar cell was manufactured by the same manner as described in Example 1 except that 60 g of titanium dioxide (particle size: approximately 0.4 $\mu$m) was added as a white pigment in preparation of an aqueous dispersion. Then, photographs of the surface of the resin layer after the aqueous dispersion was applied and melted were taken, shown in FIGS. 5 and 6, respectively.

<Examples 3 and 4>

Backsheets for a solar cell were manufactured by the same manner as described in Examples 1 and 2, respectively, except that 500 g of Hylar Latex 932 (solid content 20%) was dispersed in distilled water in an emulsion type, instead of 100 g of the non-functionalized PVDF, Hylar 561, dispersed in distilled water.

<Comparative Examples 1 and 2>

Backsheets for a solar cell were manufactured by the same manner as described in Examples 1 and 2, respectively, except that 500 g of an emulsion-type acryl-modified fluorine-based polymer (solid content 20%) functionalized with a hydroxyl group was used as the fluorine-based polymer included in the preparation of an aqueous dispersion.

**Method of Preparing Acryl-modified Fluorine-based Polymer Functionalized with Hydroxyl Group**

The acryl-modified fluorine-based polymer functionalized with hydroxyl group was prepared in a 1L high pressure reactor by adding 5 g of 15% ammonium perfluorooctanoate solution to 400 g of distilled water, adding 70 g of vinylidene fluoride (VDF) and 30 g of 2-hydroxyethyl methacrylate (2-HEMA), maintaining the reactor at 80°C, and then adding 1 g of 0.5% calcium persulfate.

<Comparative Example 3>

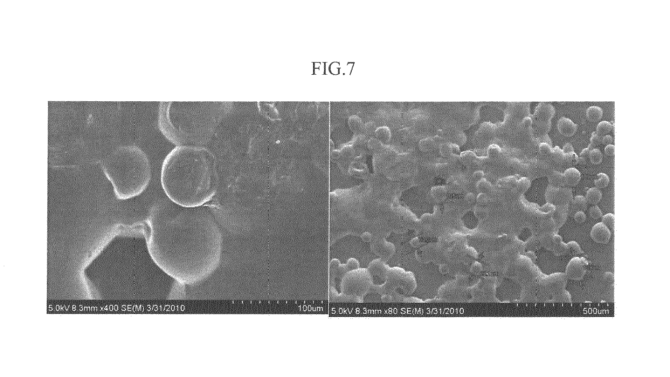

A backsheet for a solar cell was manufactured by the same manner as described in Example 1 except that 100 g of suspension-polymerized PVDF having a particle size of approximately 50 to 300 $\mu$m was used instead of the emulsion-polymerized PVDF, Hylar 561. Then, a photograph of the surface of the resin layer after an aqueous dispersion was melted was taken, shown in FIG. 7.

<Comparative Example 4>

A commercially available stacked structure of Tedlar film/adhesive/PET film/adhesive/Tedlar film was used as a backsheet for a solar cell. The stacked structure is a product manufactured by laminating Tedlar films (polyvinyl fluoride; PVF commercially available from Dupont, thickness: 38 $\mu$m) on both surfaces of a PET film through extrusion using an adhesive.

<Comparative Example 5>

A commercially available stacked structure of Tedlar film/adhesive/PET film/adhesive/Tedlar film was used as a backsheet for a solar cell. The stacked structure is a product manufactured by laminating Tedlar films (PVF commercially available from Dupont, thickness: 25 $\mu$m) on both surfaces of a PET film through casting using an adhesive.

| | | Aqueous Dispersion | | |
| --- | --- | --- | --- | --- |
| | | Fluorine-based Polymer | | Titanium Dioxide |
| | | Kind | Content (g) | Content (g) |
| | Example 1 | Hylar 561 | 100 | 0 |
| | Example 2 | Hylar 561 | 100 | 60 |
| | Example 3 | Hylar Latex 932 | 500 | 0 |
| | Example 4 | Hylar Latex 932 | 500 | 60 |
| | Comparative Example 1 | Acryl-modified Fluorine-based Polymer | 500 | 0 |
| | Comparative Example 2 | Acryl-modified Fluorine-based Polymer | 500 | 60 |
| | Comparative Example 3 | Suspension-polymerized PVDF | 100 | 0 |
| | Comparative Example 4 | Tedlar Film/Adhesive/PET Film/Adhesive/Tedlar Film | - | |

(continued)

| | Aqueous Dispersion | | |
|---|---|---|---|
| | Fluorine-based Polymer | | Titanium Dioxide |
| | Kind | Content (g) | Content (g) |
| Comparative Example 5 | Tedlar Film/Adhesive/PET Film/Adhesive/Tedlar Film | - | |

<Experimental Example 1>

180-degree peel strength and cross-hatch tests were performed on the backsheets for a solar cell manufactured in Examples 1 to 4 and Comparative Examples 1 and 5 after PCT. Specifically, each backsheet for a solar cell was left under conditions of 2 atm, 121°C and 100% R.H. for 25, 50 or 75 hours, and 180-degree peel strength and cross-hatch tests were performed to evaluate the change in adhesive strength. The evaluation results are listed in Table 2.

[Table 2]

| | Cross-Hatch Test Results | | | | 180-degree Peel Strength (N/cm) | | | |
|---|---|---|---|---|---|---|---|---|
| | Initial | 25 hrs | 50 hrs | 75 hrs | Initial | 25 hrs | 50 hrs | 75 hrs |
| Example 1 | 5B | 5B | 5B | 5B | Coat-T | Coat-T | Coat-T | Coat-T |
| Example 2 | 5B | 5B | 5B | 5B | Coat-T | Coat-T | Coat-T | Coat-T |
| Example 3 | 5B | 5B | 5B | 5B | Coat-T | Coat-T | Coat-T | Coat-T |
| Example 4 | 5B | 5B | 5B | 5B | Coat-T | Coat-T | Coat-T | Coat-T |
| Comparative Example 1 | 5B | 4B | 3B | 1B | Coat-T | Coat-T | Coat-T | Coat-T |
| Comparative Example 2 | 5B | 5B | 3B | 1B | Coat-T | Coat-T | Coat-T | Coat-T |
| Comparative Example 3 | Not Measured | Not Measured | Not Measured | Not Measured | Not Measured | Not Measured | Not Measured | Not Measured |
| Comparative Example 4 | 5B | 5B | 5B | 5B | PVF-T | PVF-T | PVF-T | 1 |
| Comparative Example 5 | 5B | 5B | 5B | 2B | 6 | 5 | 3 | 1 |

As shown in Table 2, in the backsheets for a solar cell according to examples of the present invention, a melted product of the aqueous dispersion including the non-functionalized fluorine-based polymer, the resin layer, exhibited high initial adhesive strength with respect to the substrate (PET), and even after the PCT was performed for 75 hours, it still exhibited excellent adhesive strength. In addition, even after 75 hours of the PCT, no change in appearance of the resin layer such as peeling of an interface or generation of a pin hole was shown.

However, it was confirmed that adhesive strength was decreased after the PCT in Comparative Examples 1 and 2 using a functionalized fluorine-based polymer, compared to the cases using a non-functionalized fluorine-based polymer.

The aqueous dispersion in Comparative Example 3 was difficult to have a good coated appearance since PVDF having different sizes and shapes were dispersed in water. However, when the emulsion-polymerized PVDF was used (Examples 1 to 4), the particle size was relatively small and uniform, and thus it was confirmed that a good coated appearance may be obtained through a melting process. When the suspension-polymerized, not emulsion-polymerized, PVDF (in Comparative Example 3) was used, the particle size was large and not uniform, and thus the PVDF could not be completely melted on the PET substrate.

Contrarily, it was confirmed that the Tedlar film (Example 4 or 5) produced by Dupont, which is a commercially available multi-layer film, was significantly decreased in adhesive strength with respect to the substrate as the PCT progressed.

<Experimental Example 2>

180-degree peel strength and cross-hatch tests were performed on the backsheets for a solar cell manufactured in Examples 1 to 4 and Comparative Examples 1 and 5 after the damp heat test was performed, respectively. Specifically, each backsheet for a solar cell was left under conditions of 85 °C and 85% R.H. for

1000, 2000 or 3000 hours, and 180-degree peel strength and cross-hatch tests were performed to evaluate the change in peel strength. The evaluation results are listed in Table 3.

[Table 3]

| | Cross-Hatch Test Results | | | | 180-degree Peel Strength (N/cm) | | | |
|---|---|---|---|---|---|---|---|---|
| | Initial | 1000 hrs | 2000 hrs | 3000 hrs | Initial | 1000 hrs | 2000 hrs | 3000 hrs |
| Example 1 | 5B | 5B | 5B | 5B | Coat-T | Coat-T | Coat-T | Coat-T |
| Example 2 | 5B | 5B | 5B | 5B | Coat-T | Coat-T | Coat-T | Coat-T |
| Example 3 | 5B | 5B | 5B | 5B | Coat-T | Coat T | Coat-T | Coat-T |
| Example 4 | 5B | 5B | 5B | 5B | Coat-T | Coat-T | Coat-T | Coat-T |
| Comparahve Example 1 | 5B | 3B | 2B | 0B | Coat-T | Coat-T | Coat-T | 0 |
| Comparative Example 2 | 5B | 5B | 3B | 1B | Coat-T | Coat T | Coat-T | Coat-T |
| Comparative Example 3 | Not Measured | Not Measured | Not Measured | Not Measured | Not Measured | Not Measured | Not Measured | Not Measured |
| Comparative Example 4 | 5B | 5B | 5B | 5B | PVF-T | PVF-T | PVF-T | 1 |
| Comparative Example 5 | 5B | 5B | 0B | 0B | 6 | 5 | 3 | 1 |

As shown in Table 3, in the backsheets for a solar cell according to examples of the present invention, a resm layer which is a melted product of the aqueous dispersion including the non-functionalized fluorine-based polymer exhibited high initial adhesive strength with respect to a substrate (PET), and even after the damp heat test was performed for 3,000 hours, still exhibited excellent adhesive strength. In addition, even after 3,000 hours of the damp heat test, no change in appearance of the resin layer such as peeling of an interface or generation of a pin hole was shown.

From Comparative Examples 1 and 2 using a functionalized fluorine-based polymer, compared to the cases using a non-functionalized fluorine-based polymer, it was confirmed that adhesive strength was decreased after the damp heat test.

When the suspension-polymerized, not emulsion-polymerized, PVDF (Comparative Example 4) was used, the particle size was large and not uniform, and thus the PVDF could not be completely melted on the PET substrate.

Contranly, it was confirmed that the Tedlar film (Example 4 or 5) produced by Dupont, which is a commercially available multi-layer film, was significantly decreased in adhesive strength with respect to the substrate as the PCT progressed.

<Experimental Example 3>

YI values were obtained by performing the PCT to the backsheets for a solar cell according to Examples 1 to 4 and Comparative Examples 1 and 5, and therefrom YI vanations ($\triangle$YI) were measured. Specifically, each backsheet for a solar cell was left under conditions of 2 atm, 121°C and 100% R.H. for 25, 50 or 75 hours, and reflectivity was performed at a wavelength of 400 to 800 nm using a Shimadzu UV Vis spectrometer (UV-3000) to obtain YI values. The results are listed in Table 4.

[Table 4]

| | YI | | | | △YI | | | |
|---|---|---|---|---|---|---|---|---|
| | Initial | 25 hrs | 50 hrs | 75 hrs | Initial | 25 hrs | 50 hrs | 75 hrs |
| Example 1 | -12.3 | -11.7 | 12.1 | -11.9 | - | 0.6 | 0.2 | 0.4 |
| Example 2 | -3.1 | -3.0 | -2.9 | -2.7 | - | 0.1 | 0.2 | 0.4 |
| Example 3 | -12.5 | 12.3 | -11.9 | -11.8 | - | 0.2 | 0.6 | 0.7 |
| Example 4 | -3.5 | -3.3 | -3.1 | -3.1 | - | 0.2 | 0.4 | 0.4 |
| Comparative Example 1 | -11.5 | -7.5 | -7.3 | -6.9 | - | 4 | 4.2 | 4.6 |
| Comparative Example 2 | -2.5 | 2.7 | 3.1 | 3.4 | - | 5.2 | 5.6 | 5.9 |
| Comparative Example 3 | Not Measured | Not Measured | Not Measured | Not Measured | Not Measured | Not Measured | Not Measured | Not Measured |
| Comparative Example 4 | 0.7 | 1.4 | 3.6 | 7.3 | | 0.7 | 2.9 | 6.6 |
| Comparative Example 5 | 6.2 | 6.4 | 6.5 | 6.5 | - | 0.2 | 0.3 | 0.3 |

EP 2 688 111 A2

As shown in Table 4, it was confirmed that almost no values of YI changed after the PCT was shown in the resin layer, which is a melted product of the aqueous dispersion including a non-functionalized fluorine-based polymer. Contrarily, it was confirmed that significant YI changes were shown in Comparative Examples 1 and 2 using the functionalized fluorine-based polymer, and Comparative Examples 4 and 5 using the Tedlar film produced by Dupont.

<Experimental Example 4>

YI values were obtained by performing a damp heat test on the backsheets for a solar cell according to Examples 1 to 4 and Comparative Examples 1 and 5, and therefrom YI variations (△YI) were measured. Specifically, each backsheet for a solar cell was left in an oven under conditions of 85°C and 85% R.H. for 1,000, 2,000 or 3,000 hours, and reflectivity was performed at a wavelength of 400 to 800 nm using a Shimadzu UV Vis spectrometer (UV-3000) to obtain YI values. The results are listed in Table 5.

[Table 5]

| | YI | | | | △YI | | | |
|---|---|---|---|---|---|---|---|---|
| | Initial | 1000 hrs | 2000 hrs | 3000 hrs | Initial | 1000 hrs | 2000 hrs | 3000 hrs |
| Example 1 | -12.3 | -11.4 | -11.1 | -10.5 | | 0.9 | 1.2 | 1.8 |
| Example 2 | -3.1 | -2.5 | -2.1 | -1.9 | - | 0.6 | 1.0 | 1.2 |
| Example 3 | -12.5 | -12.3 | -11.7 | -11.5 | | 0.2 | 0.8 | 1.0 |
| Example 4 | -3.5 | -2.5 | -2.2 | -1.8 | - | 1.0 | 1.3 | 1.7 |
| Comparative Example 1 | -11.5 | -7.5 | -7.2 | -6.9 | - | 4 | 4.3 | 4.6 |
| Comparative Example 2 | -2.5 | 3.5 | 3.5 | 3.6 | - | 6.0 | 6.0 | 6.1 |
| Comparative Example 3 | Not Measured | Not Measured | Not Measured | Not Measured | Not Measured | Not Measured | Not Measured | Not Measured |
| Comparative Example 4 | 0.7 | 1.9 | 3.0 | 8.7 | - | 1.22 | 2.35 | 8.05 |
| Comparative Example 5 | 6.2 | 7.9 | 9.0 | 9.4 | - | 1.68 | 2.76 | 3.16 |

As shown in Table 5, it was confirmed that almost no values of YI changed after the damp heat test was shown in a resin layer, which is a melted product of the aqueous dispersion including a non-functionalized fluorine-based polymer. Contrarily, it was confirmed that significant YI changes were shown in Comparative Examples 1 and 2 using the functionalized fluorine-based polymer, and Comparative Examples 4 and 5 using the Tedlar film produced by Dupont.

A backsheet for a solar cell according to the exemplary embodiments of the present invention does not include a process of removing an organic solvent (dry process), compared to a conventional process of preparing an organic solvent. Accordingly, since the backsheet does not use a toxic organic solvent, it is environmentally friendly and has excellent physical properties under severe conditions such as high temperature and humidity, and thus can be improved in productivity and product quality. In addition, when the backsheet does not use a functionalized fluorine-based polymer, it can have better weather resistance.

While the invention has been shown and described with reference to certain exemplary embodiments thereof, it will be understood by those skilled in the art that various changes in form and details may be made therein without departing from the scope of the invention as defined by the appended claims.

**Claims**

1.    A backsheet for a solar cell comprising:

a substrate; and
a resin layer having a fluorine-based polymer formed on at least one surface of the substrate,
wherein the resin layer is a coating layer formed with a dispersion composition including water and a fluorine-based polymer.

2.    The backsheet of Claim 1, which satisfies the following Equation 1:

$$[\text{Equation 1}]$$

$$\triangle \text{YI} = \text{YI}_b - \text{YI}_a < 3$$

wherein $\triangle$YI is a value obtained by subtracting YI value ($\text{YI}_a$) obtained after the backsheet is left for 0 hours at 121 °C and a relative humidity of 100% under 2 atm from YI value ($\text{YI}_b$) obtained after the backsheet is left under high temperature and humidity, the YI value is a yellowness index obtained after reflectivity at 400 to 800 nm is measured, and $\text{YI}_b$ is a value obtained after the backsheet is left under pressure cooker test (PCT) conditions [121 °C, relative humidity: 100%] for 75 hours or at 85 °C and a relative humidity of 85% for 3000 hours.

3.    The backsheet of Claim 1, wherein the water is included at a content of 100 to 2000 parts by weight based on 100 parts by weight of the fluorine-based polymer in the dispersion composition.

4.    The backsheet of Claim 1, wherein the fluorine-based polymer includes a homopolymer or a copolymer including at least one monomer, in a polymerized form, selected from the group consisting of vinylidene fluoride (VDF), vinyl fluoride (VF), tetrafluoroethylene (TFE), hexafluoropropylene (HFP), chlorotrifluoroethylene (CTFE), trifluoroethylene, hexafluoroisobutylene, perfluoro butylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD) and perfluoro-2-methylene-4-methyl-1,3-dioxolane (PMD), or a mixture thereof.

5.    The backsheet of Claim 1, wherein the fluorine-based polymer includes a homopolymer or copolymer including polymerized vinyl fluoride, a homopolymer or copolymer including polymerized vinylidene fluoride, or a mixture thereof.

6.    The backsheet of Claim 1, wherein the fluorine-based polymer includes a copolymer of vinylidene fluoride (VDF) or vinyl fluoride (VF) and at least one comonomer selected from the group consisting of tetrafluoroethylene (TFE), hexafluoropropylene (HFP), chlorotrifluoroethylene (CTFE), trifluoroethylene, hexafluoroisobutylene, perfluoro butylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD) and perfluoro-2-methylene-4-methyl-1,3-dioxolane (PMD), or a mixture thereof.

7. The backsheet of Claim 1, wherein the fluorine-based polymer is a non-functionalized fluoropolymer.

8. The backsheet of Claim 1, wherein the fluorine-based polymer is prepared by emulsion polymerization.

9. The backsheet of Claim 1, wherein the fluorine-based polymer has a particle size of 10 $\mu$m or less.

10. The backsheet of Claim 1, wherein the dispersion composition further includes a surfactant.

11. The backsheet of Claim 10, wherein the surfactant is included at a content of 0.01 to 10 parts by weight based on 100 parts by weight of the fluorine-based polymer.

12. The backsheet of Claim 1, wherein the dispersion composition further includes a pigment.

13. The backsheet of Claim 12, wherein the pigment is included at a content of 1 to 200 parts by weight based on 100 parts by weight of the fluorine-based polymer.

14. The backsheet of Claim 1, wherein the fluorine-based polymer has a weight average molecular weight of 50,000 to 1,000,000.

15. The backsheet of Claim 1, wherein the fluorine-based polymer has a melting point of 80°C to 175°C.

16. The backsheet of Claim 1, wherein the substrate is a metal film or polymer film.

17. The backsheet of Claim 1, wherein the polymer film is an acryl film, a polyolefin film, a polyamide film, a polyurethane film or a polyester film.

18. The backsheet of Claim 1, wherein the polyester film is a single sheet, a stacked sheet or a coextruded product of a polyethylene terephthalate (PET) film, a polyethylene naphthalate (PEN) film or a polybutylene terephthalate (PBT) film.

19. The backsheet of Claim 1, wherein the substrate has a thickness of 50 to 500 $\mu$m.

20. The backsheet of Claim 1, wherein the resin layer has a thickness of 1 to 50 $\mu$m.

21. The backsheet of Claim 1, further comprising a primer layer between the substrate and the resin layer.

22. The backsheet of Claim 1, wherein the resin layer further includes a filler, a UV stabilizer, a thermal stabilizer or a barrier particle.

23. A method of manufacturing a backsheet for a solar cell, comprising:

applying a dispersion composition including a fluorine-based polymer and water to at least one surface of a substrate; and
forming a resin layer by melting the applied dispersion composition.

24. The method of Claim 23, wherein the backsheet for a solar cell satisfies the following Equation 1:

$$[\text{Equation 1}]$$

$$\triangle YI = YI_b - YI_a < 3$$

wherein $\triangle$YI is a value obtained by subtracting YI value ($YI_a$) obtained after the backsheet is left for 0 hours at 121°C and a relative humidity of 100% under 2 atm from YI value ($YI_b$) obtained after the backsheet is left under high temperature and humidity, the YI value is a yellowness index obtained after reflectivity at 400 to 800 nm is measured, and $YI_b$ is a value obtained after the backsheet is left under pressure cooker test (PCT) conditions [121°C, relative humidity: 100%] for 75 hours or at 85°C and a relative humidity of 85% for 3000 hours.

25. The method of Claim 23, wherein the dispersion composition further includes at least one selected from the group consisting of a surfactant and a pigment.

26. The method of Claim 23, wherein the melting is performed at 150°C to 250°C.

27. The method of Claim 23, further comprising forming a primer layer on at least one surface of the substrate before forming the resin layer.

28. A solar cell comprising a backsheet for a solar cell according to any of Claims 1 to 22.

FIG.1

FIG.2

Aqueous Dispersion in which
Polyvinylidene Fluoride is Dispersed

Application

Substrate

Melting

Polyvinylidene Fluoride
Substrate

FIG.3

FIG.4

FIG.5

FIG.6

FIG.7

**EP 2 688 111 A2**

## REFERENCES CITED IN THE DESCRIPTION

### Patent documents cited in the description

- KR 20110023839
- KR 20120025681